# FASCICULE DE BREVET EUROPEEN

(11) **EP 0 665 587 B1**
(45) Date de publication et mention de la délivrance du brevet: **07.04.1999**
(21) Numéro de dépôt: 95400149.1
(22) Date de dépôt: 24.01.1995
(51) Int. Cl.: H01L 21/68

(54) **Substrat pour composants intégrés comportant une couche mince et son procédé de réalisation**
Substrat für integrierte Bauelemente mit einer Dünnschicht und Herstellungsverfahren
Substrate for integrated components having a thin film and method of realisation

(30) Priorité: 26.01.1994 FR 9400834
(43) Date de publication de la demande: 02.08.1995
(73) Titulaire: COMMISSARIAT A L'ENERGIE ATOMIQUE, 75015 Paris (FR)
(72) Inventeur: Bruel, Michel, F-38113 Veurey (FR); Biasse, Béatrice, F-38410 Uriage (FR)
(74) Mandataire: Dubois-Chabert, Guy

(56) Documents cités:
- WO-A-93/11559
- FR-A- 2 266 304

## Description

### Domaine technique

L'invention se rapporte à un substrat pour composants intégrés comportant une couche mince et à un procédé de réalisation d'un tel substrat.

On entend par composants intégrés, aussi bien des circuits électroniques (tels que des transistors, des mémoires, des microprocesseurs, ...) des composants optiques ou optoélectroniques (tels que des miroirs, des diodes électroluminescentes, des modulateurs électro-optiques ou électroacoustiques, ...), ou des capteurs (tels que des capteurs de pression, de température, ...).

De façon plus générale, on entend par composant l'ensemble des éléments pouvant être réalisés sur une couche mince.

L'invention s'applique particulièrement bien au domaine de la microélectronique et notamment à la fabrication de circuits intégrés sur des films minces.

### Etat de la technique antérieure

L'un des principaux rôles des substrats en microélectronique est de constituer un support mécanique pour les composants réalisés à leur surface. Ce rôle de support est particulièrement important lors de la réalisation même des composants. Cependant, dès lors que les composants sont réalisés, le substrat peut, dans certains cas, s'avérer encombrant.

Aussi, essaye-t-on pour un certain nombre d'applications d'obtenir les composants sur des substrats en couche mince. Comme l'épaisseur de tels substrats minces ne leur confère en général pas une rigidité suffisante pour résister aux traitements et contraintes mécaniques de la fabrication des composants, il est nécessaire de recourir à un substrat plus épais pendant leur fabrication.

Pour obtenir finalement les substrats en couche mince, il est alors possible par exemple de procéder à une abrasion du substrat. Une autre solution consiste à cliver le substrat pour en détacher une couche mince superficielle comportant les composants.

On entend par clivage toute séparation, préférentiellement selon un plan, en deux parties du substrat.

Ces opérations de clivage ou d'abrasion font cependant subir aux composant des contraintes mécaniques et/ou thermiques qui peuvent leur être fatales.

Le document FR-A-2 266 304 montre un dispositif permettant de maintenir des objets plans pendant leur traitement.

Toutefois l'utilisation du dispositif de maintien nécessite l'établissement d'une dépression dans des cavités d'une couche de maintien du dispositif.

Par ailleurs, le document WO 93/11559 concerne un procédé de réalisation de composants semiconducteurs avec récupération du substrat par voie chimique, par dissolution chimique d'une couche intermédiaire.

Un objet de la présente invention est de proposer une solution permettant de concilier la nécessité d'un substrat suffisamment rigide et résistant pour la fabrication des composants et l'objectif d'obtenir des substrats en couche mince notamment pour leur intégration dans des structures plus complexes.

### Exposé de l'invention

A cet effet, l'invention concerne plus précisément un substrat pour composants intégrés comportant une structure de maintien, une couche mince non-conductrice pour la réalisation des composants, caractérisé en ce qu'il comporte en outre une couche intermédiaire de matériau chimiquement attaquable qui relie la structure de maintien à la couche mince, la couche intermédiaire étant parcourue par au moins un canal d'attaque chimique.

On entend par couche non-conductrice aussi bien une couche unique réalisée en matériau semi-conducteur ou en matériau isolant qu'un ensemble de sous-couches dont au moins une est réalisée en matériau semi-conducteur ou isolant.

La structure de maintien est avantageusement beaucoup plus épaisse que la couche mince.

Elle confère au substrat sa résistance mécanique aux traitements et évite toute déformation ou tout déchirement de la couche mince superficielle dans laquelle, ou sur laquelle sont réalisés les composants.

Un des rôles de la couche intermédiaire est justement de maintenir fermement la couche mince sur le substrat pendant la formation des composants intégrés et d'éviter donc son déchirement.

Le principal rôle de la couche intermédiaire est cependant de permettre la dissociation de la couche mince et du substrat.

Comme la couche intermédiaire est en un matériau chimiquement attaquable, il est possible après la réalisation des composants intégrés, d'éliminer cette couche intermédiaire chimiquement et donc de libérer la couche mince. Au cours de cette opération, la couche intermédiaire est attaquée chimiquement. Les composants intégrés ne subissent par conséquent ni contrainte mécanique, ni contrainte thermique.

Eventuellement, si la nature des matériaux utilisés pour la réalisation des composants intégrés l'exige, une couche protectrice peut être prévue pour les protéger lors de l'attaque chimique.

Selon une caractéristique importante de l'invention, la couche intermédiaire est parcourue par un ou plusieurs canaux. Ces canaux permettent d'irriguer largement et en profondeur la couche intermédiaire lors d'un bain chimique. Le produit chimique pour l'attaque de la couche intermédiaire peut ainsi circuler dans cette couche de manière à l'éliminer non seulement en périphérie, mais aussi en profondeur, le plus complètement possible. Il est en effet très important de libérer complètement la couche mince pour ne pas la détériorer en la séparant du substrat.

La réalisation de canaux dans la couche intermédiaire permet une attaque beaucoup plus rapide et homogène de celle-ci. Ces canaux peuvent être réalisés à n'importe quel niveau dans l'épaisseur de la couche intermédiaire mais pour des facilités de réalisation ils sont réalisés à partir de la surface de cette couche. Par ailleurs, la profondeur des canaux peut atteindre l'épaisseur de la couche intermédiaire.

Selon un aspect de l'invention, la couche intermédiaire est parcourue par un réseau orthogonal de canaux qui permet de répartir au mieux l'attaque chimique de la couche intermédiaire sur toute la surface qui la relie à la couche mince.

Selon une variante, la couche peut être parcourue aussi par un seul canal replié par exemple en serpentin ou en spirale.

Le réseau de canaux ou le tracé du canal dans le cas d'un canal unique doit être suffisamment dense pour permettre une attaque chimique rapide et uniformément répartie, mais les canaux ne peuvent pas être trop larges ou avoir une section trop importante pour ne pas nuire à la fonction de maintien de la couche intermédiaire.

De manière avantageuse, pour éviter que la couche intermédiaire ne subisse les traitements chimiques nécessaires à la réalisation des composants intégrés, le ou les canaux sont fermés par une bordure de la couche. La bordure, qui obture latéralement les extrémités des canaux est prévue suffisamment épaisse pour résister aux traitements chimiques. Comme les canaux ne débouchent pas, la couche intermédiaire est éventuellement perturbée qu'en périphérie par les traitements de fabrication des composants intégrés.

Avant l'attaque chimique, la bordure est éliminée pour ouvrir les canaux. Cette ouverture des canaux vers l'extérieur est réalisable sans perturber les composants intégrés en attaquant au moins une partie du pourtour de la couche intermédiaire, et donc la bordure, par gravure sèche. Une autre solution consiste à attaquer la couche dans des zones correspondant aux lignes de découpe des composants intégrés.

Selon l'invention, le procédé de fabrication du substrat comporte les étapes successives suivantes :
a) formation sur une structure de maintien d'une couche intermédiaire d'un matériau chimiquement attaquable, et présentant une face libre sensiblement plane,
b) gravure de la couche intermédiaire par la face libre pour former au moins un canal d'attaque chimique parcourant ladite couche, et en préservant dans la couche une bordure de fermeture du ou des canaux,
c) report sur la face libre de la couche intermédiaire d'une couche mince non-conductrice pour la formation des composants intégrés, obturant le canal sur ladite face, ladite couche mince étant détachable de la structure de maintien par attaque chimique de la couche intermédiaire.

Pour l'obtention de composants intégrés sur un substrat mince, le procédé est poursuivi par les étapes suivantes :
d) formation de composants intégrés sur la couche mince,
e) ouverture du ou des canaux d'attaque chimique,
f) élimination de la couche intermédiaire par attaque chimique à travers le ou les canaux pour détacher la couche mince de la structure de maintien.

La gravure du ou des canaux peut avantageusement avoir lieu soit selon des procédés classiques, tels qu'une gravure sèche ou humide à travers un masque approprié, soit par un procédé de gravure comprenant un traitement laser poursuivi par une attaque chimique anisotrope. Une telle technique est décrite par exemple dans le document "Laser Machining and Anisotropic Etching of <111> Silicon for Applications in Microsystems" de M. Alavi et al. dans "Micro System Technologies 92", 3rd International Conference on Micro Electro, Opto, Mechanic Systems and Componants, Berlin, Octobre 21-23, 1992, vde-verlag gmbh - Herbert Reichl, Berlin Offenbach.

Cette technique est basée sur la différence de vitesse d'attaque des plans cristallographiques <111> par rapport aux autres plans cristallographiques.

Selon cette technique, on détruit localement les plans cristallographiques <111> par fusion locale de la couche à graver au moyen d'un faisceau laser. Dans un deuxième temps, un traitement chimique permet d'éliminer les zones attaquées par le faisceau laser, les plans <111> non détruits servant alors de "couche d'arrêt". Grâce à cette technique, il est possible d'obtenir des canaux dont on peut contrôler très précisément la largeur, la profondeur et l'emplacement.

Lorsque la couche mince est appliquée sur la face libre de la couche intermédiaire, elle vient recouvrir le ou les canaux. Les canaux sont donc isolés de l'extérieur.

Avantageusement, ce report peut être effectué sous atmosphère contrôlée, de façon à emprisonner dans les canaux une pression de gaz compatible avec les traitements thermiques utilisés pour la fabrication des composants.

Pour réaliser le report d'une couche mince sur la couche intermédiaire, ou plus précisément pour obtenir la couche mince elle-même, plusieurs solutions sont possibles.

Il est possible par exemple de reporter sur la couche intermédiaire un second substrat ou une couche épaisse, puis d'abraser cette couche pour l'obtention de la couche mince.

Les contraintes mécaniques ou thermiques d'une telle abrasion ne sont en général pas préjudiciables car à ce stade les composants intégrés ne sont pas encore formés.

Toutefois, on a avantageusement recours à une méthode de clivage de mise en oeuvre plus facile et mieux adaptée à la présente application.

Selon cette méthode, on reporte sur la couche intermédiaire une structure clivable, au niveau d'un plan de clivage. Ce plan de clivage peut être créé par exemple par implantation d'ions de gaz rare ou d'hydrogène dans la structure à partir d'une face plane. Cette implantation génère des microbulles gazeuses au niveau de ce plan qui délimite ainsi dans la structure clivable d'une part une partie dite massive, et, d'autre part, la future couche mince. Un exemple de réalisation de structure clivable est notamment illustré dans la demande de brevet EP-A-0 533 551. La structure clivable est reportée sur la couche intermédiaire en mettant en contact cette dernière avec la partie de la structure constituant la future couche mince. La structure clivable est rendue solidaire de la couche intermédiaire, par exemple par des liaisons inter-atomiques. Lorsque le report est effectué, un traitement thermique permet de provoquer le clivage selon le plan défini par les microbulles.

### Brève description des figures

- la figure 1 est une coupe A-A diamétrale schématique selon un canal d'un substrat cylindrique conforme à l'invention,
- la figure 2 est une coupe B-B schématique d'un substrat, selon une face d'une couche intermédiaire,
- les figures 3 à 5 sont des coupes A-A diamétrales schématiques illustrant un procédé de fabrication du substrat selon l'invention,
- la figure 6 illustre une coupe A-A d'un substrat selon l'invention préparé pour la dissociation d'une couche superficielle.

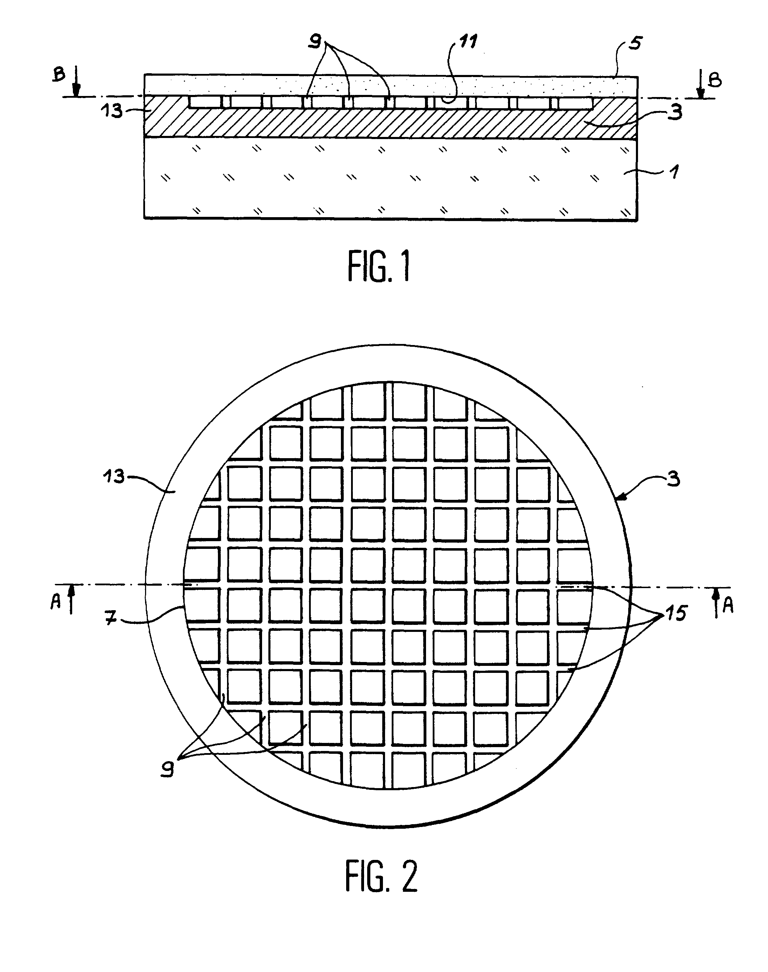

Le substrat illustré à la figure 1 a une forme générale cylindrique et comporte une structure de maintien mécanique 1, par exemple une plaque de silicium ou de verre, une couche intermédiaire 3 en un matériau chimiquement attaquable et une couche mince 5.

La couche 5 constitue elle-même un "substrat" pour la réalisation de composants intégrés, elle peut être formée aussi bien par une couche unique réalisée en matériau semi-conducteur ou en matériau isolant que par un ensemble de sous-couches dont au moins une est réalisée en matériau semi-conducteur ou isolant. Tel est le cas dans l'exemple décrit où la couche 5 est en silicium monocristallin. Son épaisseur est de l'ordre, par exemple, de 1 µm.

Dans la couche 3, on peut distinguer une région centrale 7 parcourue par des canaux 9. Les canaux 9 affleurant à une face supérieure 11 de la couche 3 sont répartis uniformément dans la région 7.

La région 7 est entourée par une bordure circulaire 13 qui ferme latéralement les canaux 9.

Sur les figures, la section des canaux et l'épaisseur de la couche 3 sont exagérées par rapport à la largeur de la bordure 13.

La bordure 13 est suffisamment large pour rester insensible aux traitements accompagnant la formation de composants intégrés dans la couche mince 5. A titre d'exemple, la bordure 13 a une largeur de 4 mm, alors que la couche 3 a une épaisseur de l'ordre de 10 µm. Les canaux ont une largeur pouvant aller de 2 µm à 50 µm.

Sur la face 11, les canaux 9 sont obturés par l'application contre cette face de la couche mince 5.

La face 11 et la répartition des canaux 9 apparaissant plus clairement à la figure 2 qui est une coupe B-B parallèlement à cette face.

En particulier, on constate que les extrémités 15 des canaux 9 sont obturés par la bordure 13 qui délimite la région centrale 7.

Les canaux 9 forment un réseau orthogonal.

A titre d'exemple, le pas de ce réseau est de 100 µm pour des canaux 9 d'une largeur de 10 µm.

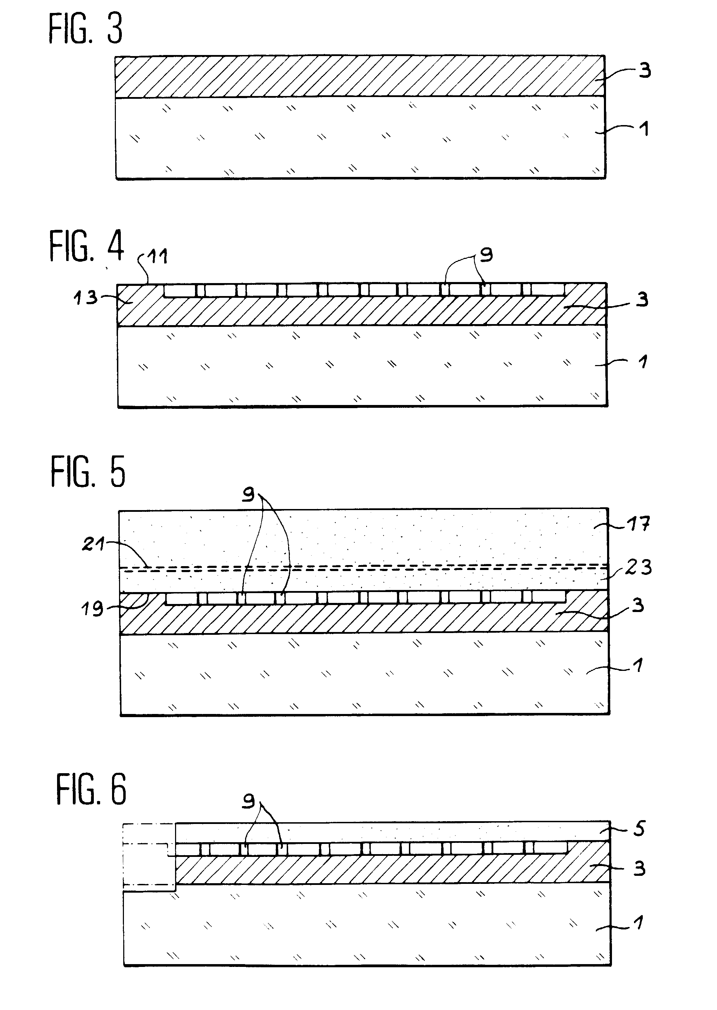

Les figures 3 à 5 permettent de mieux comprendre les étapes de la fabrication d'un substrat selon un aspect de l'invention.

Dans une première étape, correspondant à la figure 3, on forme sur une structure 1, qui constitue un premier substrat, par exemple en silicium, une couche 3 attaquable chimiquement. On dépose par exemple une couche d'oxyde de silicium de 10 µm d'épaisseur. Ce dépôt peut avoir lieu par dépôt chimique en phase vapeur.

La couche 3 est ensuite gravée dans une région centrale 7 pour former des canaux 9. La gravure peut avoir lieu, par exemple, soit par gravure sèche ou humide à travers un masque approprié, soit selon une technique connue alliant un traitement par faisceau laser et un traitement chimique.

Une étape suivante consiste à reporter sur la face 11 de la couche 3 une seconde structure 17 qui est par exemple clivable. Il s'agit à titre d'exemple d'un bloc de silicium monocristallin présentant une face 19 sensiblement plane. Une couche 21 de microbulles gazeuses a été préalablement créée par implantation dans la structure 17.

La couche 21, sensiblement parallèle à la face 19 constitue un plan de clivage et délimite dans la structure 17 une partie superficielle 23 qui constitue la future couche mince.

Le report est effectué en solidarisant par exemple par des liaisons inter-atomiques la structure 17 sur la couche 3, par sa partie superficielle 23. On obtient un ensemble représenté à la figure 5.

Une étape de clivage de la structure 17 permet d'en détacher la partie 23 qui devient la couche mince 5 du substrat de l'invention tel que représenté en figure 1. L'épaisseur de cette couche est de l'ordre du micromètre.

A ce moment, le substrat est prêt pour la réalisation de composants intégrés.

Les composants sont réalisés dans la couche mince ou sur la couche mince selon des techniques connues en soi.

Une couche de protection non représentée, en un matériau tel que le nitrure de silicium est prévue éventuellement pour protéger les composants.

Quand les composants intégrés sont formés et protégés, on peut procéder à la séparation de la couche mince 5 de la structure de maintien 1.

Comme le montre la figure 6, on élimine au moins partiellement la bordure 13 qui entoure la région 7 du substrat. Les canaux 9 sont donc ouverts vers l'extérieur.

Dans cet exemple de réalisation, pour éliminer la bordure 13, on attaque préalablement la couche mince par gravure. Cette gravure a lieu par exemple par voie sèche, sur le pourtour du substrat et dans une région où il n'y a pas de composants intégrés. Elle ne perturbe donc pas les composants.

Dans les zones découvertes de la couche 5, la couche intermédiaire est alors gravée afin d'éliminer au moins une partie de la bordure et ouvrir les canaux.

Après cette gravure, le substrat est soumis à un bain chimique qui attaque sélectivement la couche 3 dans son volume grâce aux canaux 9. Dans le présent cas où la couche 3 est en oxyde de silicium, on aura recours à un bain d'acide fluorhydrique (FH).

La cinétique de l'attaque chimique peut être contrôlée par la température du bain ainsi que par un éventuel mouvement d'agitation de celui-ci.

Les composants intégrés sont protégés lors de cette attaque par la couche de nitrure de silicium non représentée.

Dès que la couche 3 est gravée au moins entièrement selon un plan parallèle aux couches, la couche mince 5 se détache de la structure 1.

Ainsi, grâce à l'invention, on dispose d'un substrat suffisamment rigide et résistant pour la formation de composants intégrés et qui permette d'obtenir une couche mince sans endommager les composants.

## Revendications

1. Substrat pour composants intégrés comportant une structure (1) de maintien, une couche mince (5) non-conductrice pour la réalisation des composants intégrés disposés sur cettes structure et une couche intermédiaire (3) de matériau chimiquement attaquable entre la structure (1) de maintien mécanique et la couche mince (5), caractérisé en ce que la couche intermédiaire (3) est parcourue par au moins un canal (9) d'attaque chimique.

2. Substrat selon la revendication 1, dans lequel la couche intermédiaire (3) est parcourue par un ou plusieurs canaux d'attaque chimique (9) communiquant entre eux et/ou avec l'extérieur, au moins un des canaux pouvant être mis en communication avec l'extérieur.

3. Substrat selon la revendication 1, caractérisé en ce que le canal (9) d'attaque chimique est fermé par une bordure (13) de la couche intermédiaire (3).

4. Substrat selon la revendication 1 ou 3, caractérisé en ce que la couche intermédiaire (3) est parcourue par des canaux (9) agencés selon un réseau orthogonal.

5. Substrat selon la revendication 4, caractérisé en ce que le réseau présente un pas de 100 µm et les canaux (9) une largeur de 10 µm.

6. Substrat selon l'une quelconque des revendications précédentes, caractérisé en ce que la couche mince (5) est réalisée en matériau semi-conducteur ou en matériau isolant.

7. Substrat selon l'une quelconque des revendications précédentes, caractérisé en ce que la couche mince (5) est une couche de silicium monocristallin d'une épaisseur d'environ 1 µm.

8. Substrat selon l'une quelconque des revendications 1 à 4, caractérisé en ce que la couche mince (5) est formée d'un ensemble de sous-couches dont au moins une sous-couche est réalisée en un matériau semi-conducteur ou isolant.

9. Substrat selon l'une quelconque des revendications précédentes, caractérisé en ce que la couche intermédiaire (3) est une couche d'oxyde de silicium d'une épaisseur d'environ 10 µm.

10. Substrat selon l'une quelconque des revendications 3 à 9, caractérisé en ce que la bordure (13) présente une largeur d'environ 4 mm.

11. Procédé de fabrication de composants intégrés sur une couche mince (5) en matériau non conducteur, caractérisé en ce qu'il comporte les étapes successives suivantes :
a) formation sur une structure (1) de maintien mécanique d'une couche dite intermédiaire (3) d'un matériau chimiquement attaquable, et présentant une face libre (11) sensiblement plane,
b) gravure de la couche intermédiaire (3) par la face libre (11) pour former au moins un canal (9) d'attaque chimique parcourant ladite couche (3), et en préservant dans la couche (3) une bordure(13) de fermeture du canal (9),
c) formation sur la face libre sensiblement plane (11) de la couche intermédiaire (3) d'une couche mince (5) non conductrice pour la formation des composants intégrés qui obture le canal (9) sur ladite face libre (11),
d) formation de composants intégrés (24) sur la couche mince (5),
e) ouverture du canal (9) d'attaque chimique,
f) élimination de la couche intermédiaire (3) par attaque chimique à travers le canal pour détacher la couche mince (5) de la structure de maintien (1).

12. Procédé selon la revendication 11, caractérisé en ce que lors de l'étape c) on reporte sur la face libre (11) de la couche intermédiaire une structure clivable (17) et on clive cette structure (17) pour en détacher la couche mince (5) en contact avec la face libre (11) de la couche intermédiaire (3).

13. Procédé selon la revendication 12, caractérisé en ce qu'avant le report de la structure clivable (17) on réalise par implantation dans cette structure (17) une couche (21) de microbulles gazeuses de manière à définir un plan de clivage délimitant dans la structure (17) la couche mince, et qu'après le report de la structure clivable (17), on effectue un traitement thermique pour réaliser le clivage selon le plan de clivage.

14. Procédé de fabrication selon la revendication 11, caractérisé en ce que le canal (9) de la couche intermédiaire est ouvert par élimination d'au moins une partie de la bordure de fermeture (13).

15. Procédé de fabrication selon la revendication 11, caractérisé en ce que le canal de la couche intermédiaire est ouvert au niveau d'au moins une ligne de découpe des composants.

## Claims

1. Substrate for integrated components comprising a support structure (1) and a thin nonconductive film (5) for producing the integrated components disposed on said structure and an intermediate film (3) made of a chemically etchable material between the mechanical support structure (1) and the thin film (5), characterized in that the intermediate film (3) is traversed by at least one chemical etching channel (9).

2. Substrate according to claim 1, wherein the intermediate film (3) is traversed by one or more chemical etching channels (9) communicating with one another and/or with the exterior, it being possible to link at least one of the channels with the exterior.

3. Substrate according to claim 1, characterized in that the chemical etching channel (9) is closed by a border (13) of the intermediate film (3).

4. Substrate according to claim 1 or 3, characterized in that the intermediate film (3) is traversed by channels (9) arranged in the form of an orthogonal network.

5. Substrate according to claim 4, characterized in that the network has a spacing of 100 µm and the channels (9) a width of 10 µm.

6. Substrate according to any one of the preceding claims, characterized in that the thin film (5) is made from a semiconductor or insulating material.

7. Substrate according to any one of the preceding claims, characterized in that the thin film (5) is a monocrystalline silicon film with a thickness of approximately 1 µm.

8. Substrate according to any one of the claims 1 to 4, characterized in that the thin film (5) is formed by a group of underfilms, whereof at least one underfilm is made from a semiconductor or insulating material.

9. Substrate according to any one of the preceding claims, characterized in that the intermediate film (3) is a silicon oxide film with a thickness of approximately 10 um.

10. Substrate according to any one of the claims 3 to 9, characterized in that the border (13) has a width of approximately 4 mm.

11. Method for producing integrated components on a thin film (5) made of a nonconductive material, characterized in that it comprises the following successive stages:
a) formation on a mechanical support structure (1) an intermediate film (3) of a chemically etchable material and having one approximately flat free face (11),
b) etching of the intermediate film (3) via the free face (11) so as to form at least one chemical etching channel (9) traversing said film (3) and thus retaining in the film (3) one border (13) for closing the channel (9),
c) formation on the approximately flat free face (11) of the intermediate film (3) of a thin nonconductive film (5) for the formation of the integrated components which seal the channel (9) on said free face (11),
d) formation of integrated components (24) on the thin film (5),
e) opening of the chemical etching channel (9),
f) elimination of the intermediate film (3) by chemical attack through the channel so as to detach the thin film (5) from the support structure (1).

12. Method according to claim 11, characterized in that during the stage c), a splittable structure (17) is applied on the free face (11) of the intermediate film and this structure (17) is split so as to detach from it the thin film (5) in contact with the free face (11) of the intermediate film (3).

13. Method according to claim 12, characterized in that, prior to the mounting of the splittable structure (17), implanted in this structure (17) is a film (21) of gaseous microbubbles so as to define a splitting plane delimiting the thin film in the structure (17), and that following the applying of the splittable structure (17), a heat treatment is carried out so as to carry out splitting along the splitting plane.

14. Production method according to claim 11, characterized in that the channel (9) of the intermediate film is opened by eliminating at least one portion of the closing border (13).

15. Production method according to claim 11, characterized in that the channel of the intermediate film is open, at least at the level of a cutting line of the components.

## Patentansprüche

1. Substrat für integrierte Bauelemente, eine Tragstruktur (1), eine nichtleitende Dünnschicht (5) zur Herstellung auf dieser Struktur angeordneter integrierter Bauelemente und eine Zwischenschicht (3) aus einem chemisch angreifbaren Material zwischen der mechanischen Tragstruktur (1) und der Dünnschicht (5) umfassend,
**dadurch gekennzeichnet**,
daß die Zwischenschicht (3) wenigstens einen chemischen Angriffskanal (9) umfaßt.

2. Substrat nach Anspruch 1, bei dem ein oder mehrere untereinander und/oder mit der Außenseite kommunizierende chemische Angriffskanäle (9) die Zwischenschicht (3) durchlaufen, wobei wenigstens einer der Kanäle mit der Außenseite verbunden werden kann.

3. Substrat nach Anspruch 1, dadurch gekennzeichnet, daß der chemische Abgriffskanal (9) durch einen Rand (13) der Zwischenschicht (3) verschlossen ist.

4. Substrat nach Anspruch 1 oder 3, dadurch gekennzeichnet, daß die Zwischenschicht (3) zu einem rechwinkligen Gitter angeordnete Kanälen (9) umfaßt.

5. Substrat nach Anspruch 4, dadurch gekennzeichnet, daß das Gitter eine Teilung von 100 µm aufweist und die Kanäle (9) eine Breite von 10 µm haben.

6. Substrat nach einem der vorangehenden Ansprüche, dadurch gekennzeichnet, daß die Dünnschicht (5) aus einem Halbleitermaterial oder aus einem Isoliermatierial hergestellt ist.

7. Substrat nach einem der vorangehenden Ansprüche, dadurch gekennzeichnet, daß die Dünnschicht (5) eine Schicht aus monokristallinem Silicium mit einer Dicke von ungefähr 1 µm ist.

8. Substrat nach einem der Ansprüche 1 bis 4, dadurch gekennzeichnet, daß die Dünnschicht (5) durch ein System von Teilschichten gebildet wird, bei dem wenigstens eine Teilschicht durch ein Halbleiter- oder Isoliermaterial gebildet wird.

9. Substrat nach einem der vorangehenden Ansprüche, dadurch gekennzeichnet, daß die Zwischenschicht (3) eine Siliciumoxidschicht mit einer Dicke von ungefähr 10 µm ist.

10. Substrat nach einem der Ansprüche 3 bis 9, dadurch gekennzeichnet, daß der Rand (13) eine Breite von ungefähr 4mm hat.

11. Verfahren zur Herstellung integrierter Bauelemente auf einer Dünnschicht (5) aus nichtleitendem Material,
dadurch gekennzeichnet, daß es die folgenden Schritte umfaßt:
a) Bilden einer mechanischen Tragstruktur einer sogenannten Zwischenschicht (3) aus einem chemisch angreifbaren Material und mit einer im wesentlichen planen bzw. ebenen freien Fläche (11),
b) Ätzen der Zwischenschicht (3) von der freien Fläche (11) her, um wenigstens einen die genannte Schicht (3) durchlaufenden chemischen Angriffskanal (9) zu bilden und dabei einen Rand (13) der Schicht (3) stehenzulassen, um den Kanal (9) zu verschließen,
c) Bilden einer nichtleitenden Dünnschicht (5) auf der im wesentlichen ebenen freien Fläche (11) der Zwischenschicht (3) zur Erzeugung integrierter Bauelemente, die den Kanal (9) auf der genannten freien Fläche (11) verschließt.
d) Erzeugen integrierter Bauelemente (24) auf der Dünnschicht (5),
e) Öffnen des chemischen Angriffkanals (9),
f) Eliminieren der Zwischenschicht (3) mittels chemischen Angriffs durch den Kanal, um die Dünnschicht (5) der Tragstruktur (1) zu entfernen.

12. Verfahren nach Anspruch 11, dadurch gekennzeichnet, daß man während des Schritts c) auf die freien Fläche (11) der Zwischenschicht eine spaltbare Struktur (17) überträgt (reporte) und man diese Struktur (17) spaltet, um von ihr die Dünnschicht (5), in Kontakt mit der freien Fläche (11) der Zwischenschicht (3), loszutrennen.

13. Verfahren nach Anspruch 12, dadurch gekennzeichnet, daß man vor dem Übertragen (report) der spaltbaren Struktur (17) durch Implantation in dieser Struktur (17) eine Schicht (21) aus Mikrogasbläschen erzeugt, um eine Spaltebene zu definieren, die in der Struktur (17) die Dünnschicht abgrenzt, und daß man nach dem Übertragen (report) der spaltbaren Struktur (17) eine Wärmebehandlung durchführt, um die Spaltung in der Spaltebene herzustellen.

14. Verfahren nach Anspruch 11, dadurch gekennzeichnet, daß der Kanal (9) der Zwischenschicht geöffnet wird durch Entfernen von wenigstens einem Teil des Verschlußrands (13).

15. Verfahren nach Anspruch 11, dadurch gekennzeichnet, daß der Kanal der Zwischenschicht in Höhe von wenigstens einer Bauelemente-Zuschneidlinie geöffnet wird.
